## Europäisches Patentamt

## European Patent Office

## Office européen des brevets

(19)

(11) Veröffentlichungsnummer: **0 037 936**
A2

(12) **EUROPÄISCHE PATENTANMELDUNG**

(21) Anmeldenummer: 81102245.8

(22) Anmeldetag: 25.03.81

(51) Int. Cl.³: **H 05 K 3/06**

(30) Priorität: 10.04.80 DE 3013819

(43) Veröffentlichungstag der Anmeldung: 21.10.81
Patentblatt 81/42

(84) Benannte Vertragsstaaten: **FR GB IT NL SE**

(71) Anmelder: **SIEMENS AKTIENGESELLSCHAFT Berlin und München, Postfach 22 02 61, D-8000 München 22 (DE)**

(72) Erfinder: **Merkenschlager, Hans-Hermann Dipl.-Ing., Speilfeldstrasse 15, D-8900 Augsburg 21 (DE)**
Erfinder: **Mayer, Heinrich, Martinistrasse 33c, D-8900 Augsburg 21 (DE)**
Erfinder: **Selbmann, Heinz-Jörg, Maisstrasse 3d, D-8900 Augsburg 21 (DE)**

(54) Verfahren zur Herstellung gedruckter Leiterplatten.

(57) Die Erfindung bezieht sich auf ein Verfahren zur Herstellung gedruckter Leiterplatten, bei dem die Kupferschicht der nach dem Bohren chemisch verkupferter Platten galvanisch auf die geforderte Endstärke auf der gesamten Fläche einschließlich der Bohrungen in einem Schritt aufgebaut wird. Anschließend wird die Leiterplatte auf der gesamten Fläche mit einer negativ arbeitenden Fotopolymerfolie beschichtet. Nach der Belichtung werden die nichtbelichteten Stellen beim Entwickeln ausgewaschen, wonach das freiliegende Kupfer weggeätzt wird. Bei diesem Verfahren führen jedoch staub- bzw. lichtundurchlässige Partikel zwischen Lichtwelle und Fotopolymerfolie bei der Belichtung zu Fehlern in der Abbildung, wie z.B. Leiterbahnunterbrechungen u.dgl. Zur Vermeidung dieses Nachteils sieht die Erfindung zur Erzeugung des Leiterbildes eine zweifache Belichtung vor. Das erfindungsgemäße Verfahren ist insbesondere für das sogenannte Tenting-Verfahren zur Erstellung gedruckter Leiterplatten geeignet, so daß nach der Belichtung die nichtbelichteten Stellen beim Entwickeln ausgewaschen werden, wonach das freiliegende Kupfer weggeätzt wird (Tenting-Verfahren).

0037936

SIEMENS AKTIENGESELLSCHAFT          Unser Zeichen
Berlin und München                  VPA 80 P 2027 E

## Verfahren zur Herstellung gedruckter Leiterplatten.

Die Erfindung betrifft ein Verfahren zur Herstellung gedruckter Leiterplatten, bei dem die Kupferschicht der
nach dem Bohren chemisch verkupferten Platten galvanisch
auf die geforderte Endstärke auf der gesamten Fläche
einschließlich der Bohrungen in einem Schritt aufgebaut
und anschließend die Leiterplatte auf der gesamten Fläche
mit einer negativ arbeitenden Fotopolymerfolie beschichtet
wird und nach der Belichtung die nicht belichteten Stellen
beim Entwickeln ausgewaschen werden, wonach das freiliegende Kupfer weggeätzt wird (Tenting-Verfahren).

Für die Herstellung von Leiterplatten gibt es verschiedene
Verfahren. Ein Verfahren, das besonders zur Herstellung
von hochwertigen Leiterplatten mit feinen Leiterbildkonfigurationen bzw. engen Toleranzen eingesetzt wird,
ist das sogenannte "Tenting-Verfahren".

Dieses Verfahren hat gegenüber den herkömmlichen den Vorteil, daß die Kupferschicht in einem Schritt aufgebracht
werden kann und daß keine Zwischenverzinnung (Metallresist) notwendig ist, wodurch Verfahrensschritte und Material eingespart werden. Bei diesem Verfahren werden
die Leiterplatten nach dem Bohren chemisch verkupfert
(durchkontaktiert). Diese chemische Kupferschicht wird
galvanisch auf die geforderte Endstärke auf der gesamten
Fläche in einem Schritt aufgebaut (panel-plating). Zur
Leiterbilderzeugung wird die Leiterplatte nun mit einer
lichtempfindlichen, negativ arbeitenden Fotopolymerfolie beschichtet, diese mittels UV-Licht und eines
Druckwerkzeuges an bestimmten Stellen, wie z. B. Leiterbahnen, Lötaugen usw. belichtet (polymerisiert) und
danach die nichtbelichteten Stellen beim Entwickeln aus-

Zk 1 Fdl/10.4.1980

gewaschen. Das freiliegende Kupfer kann dann mit einem geeigneten Ätzmedium abgeätzt werden; das Leiterbild mit Lötaugen und die Durchkontaktierungen werden dabei durch die Fotopolymerfolie geschützt. Nach dem Entfernen der Fotopolymerfolie liegt das Leiterbild in Kupferoberfläche vor und kann dann weiterbearbeitet werden.

Ein kritischer Punkt des beschriebenen Verfahrens ist die Belichtung der Fotopolymerfolie. Staub- bzw. lichtundurchlässige Partikel zwischen Lichtquelle und Fotopolymerfolie führen zu Fehlern in der Abbildung wie z. B. Leiterbahnunterbrechungen, Leiterbahneinschnürungen oder offenen Bohrungsabdeckungen und damit zu Revisions- und Retuschieraufwand bzw. zu Ätzfehlern und zur Nacharbeit der geätzten Leiterbilder in Form von Schweißen von unterbrochenen Leiterbahnen oder Nieten von ausgeätzten Bohrungsdurchkontaktierungen oder zum Verwurf der fehlerhaften Leiterplatten.

Zur Vermeidung dieser Fehler werden daher beim Tenting-Verfahren höchste Anforderungen bei der Ausführung des Belichtungsvorganges in bezug auf Sauberkeit des Arbeitsraumes, des Druckwerkzeuges und Belichtungsgerätes gestellt. Außerdem ist ein erheblicher Revisions- und Retuschieraufwand an den mit Fotopolymerfolie bedruckten Leiterplatten erforderlich, um Ätzfehler und damit Nacharbeit und Verwurf in vertretbaren Grenzen zu halten.

Aufgabe der vorliegenden Erfindung ist es, ein Tenting-Verfahren anzugeben, bei dem der Revisions- und Retuschieraufwand der bedruckten Platte sowie die Nacharbeit der geätzten Leiterbilder reduziert wird.

Zur Lösung dieser Aufgabe wird gemäß der Erfindung derart verfahren, daß zur Erzeugung des Leiterbildes eine zweifache Belichtung erfolgt.

Durch diese Maßnahmen wird erreicht, daß beim zweiten Belichtungsvorgang das Leiterbild nochmals belichtet wird, wodurch Belichtungsfehlstellen des ersten Belichtungsvorganges beseitigt werden. Dabei ist es unwahrscheinlich, daß beim ersten und zweiten Belichtungsvorgang jeweils an derselben Stelle ein Belichtungsfehler auftritt.

Eine vorteilhafte Weiterbildung des Verfahrens sieht vor, daß beim ersten Belichtungsvorgang ein Druckwerkzeug mit den gewünschten Leiterbahn- und Lötaugenabmessungen eingesetzt wird, und daß beim zweiten Belichtungsvorgang ein Druckwerkzeug mit der gleichen Leiterbildkonfiguration wie beim ersten Druck, aber mit geringerer Leiterbreite und kleineren Lötaugendurchmessern eingesetzt wird.

Der zweite Belichtungsvorgang kann auch auf einer anderen Belichtungsstation erfolgen.

Durch die geringeren Leiterbreiten und kleineren Lötaugendurchmesser des zweiten Druckwerkzeuges werden die Druckwerkzeug- und Drucktoleranzen ausgeglichen und eine unzulässige Verbreiterung der Leiterbahnen und Vergrößerung der Lötaugen bzw. eine Verschlechterung der Kantenqualität der Fotopolymerfolie durch den zweiten Belichtungsvorgang vermieden.

Die Einsparungen durch geringere Anforderungen in bezug auf Sauberkeit beim Belichten sowie durch geringeren Revisions- und Retuschieraufwand bei Druckwerkzeugen und Leiterplatten und durch geringeren Ausschuss überwiegen bei weitem die Mehraufwendungen für die Herstellung des zweiten Druckwerkzeuges sowie den zweiten Belichtungsvorgang.

Anhand der Skizzen nach den Figuren 1 bis 3 wird die Er-

0037936

findung näher erläutert.

Fig. 1 zeigt die Belichtungsanordnung,

Fig. 2 Druckwerkzeug und Druckergebnis nach dem herkömmlichen Belichtungsverfahren,

Fig. 3 Druckwerkzeug und Druckergebnis nach dem erfindungsgemäßen Verfahren.


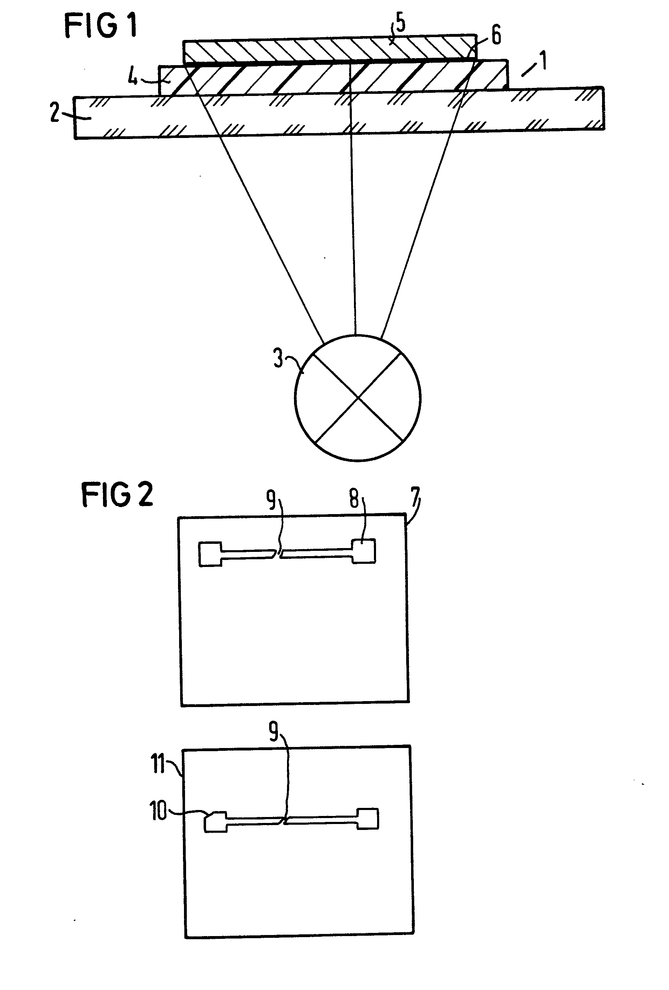

In Fig. 1 ist die Belichtungsanordnung dargestellt. Auf ein Belichtungsgerät 1, das eine Glasscheibenauflage 2 enthält, die von hinten her über eine Lichtquelle 3 angestrahlt wird, ist das als Schalblone dienende Druckwerkzeug 4 aufgelegt. Oberhalb des Druckwerkzeuges 4 ist die Leiterplatte 5, die mit einer negativ arbeitenden Fotopolymerfolienbeschichtung 6 versehen ist, aufgebracht.


In Fig. 2 ist im oberen Teil das Druckwerkzeug 7 gezeigt, das beispielsweise der Einfachheit halber nur eine Leiterbahn 8 aufweisen soll, die an der Stelle 9 unterbrochen ist.


Unterhalb des Druckwerkzeuges ist das fertige Druckprodukt, z. B. die gedruckte Leiterplatte dargestellt. Man erkennt, daß die Leiterbahnunterbrechung, die durch einen Druckwerkzeugfehler verursacht wurde, weiterhin erhalten ist. Gleichzeitig ist ein Lötaugenfehler 10 vorhanden, der beispielsweise durch Staubpartikel zwischen der Lichtquelle und der Fotopolymerfolie verursacht sein soll.


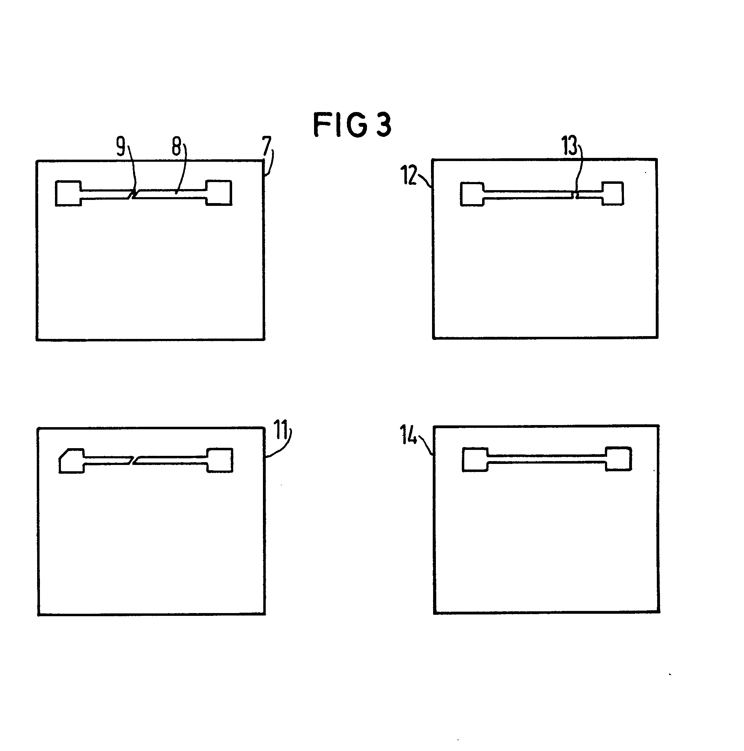

In Fig. 3 ist links oben das Druckwerkzeug 7 mit einer Leiterbahn 8, die eine Unterbrechung 9 aufweist, gezeigt. Darunter ist wieder das belichtete Objekt, z. B. eine Leiterplatte, zu sehen, die die gleichen Fehler wie die Leiterplatte in Fig. 1 aufweist. Rechts daneben ist der zweite Belichtungsvorgang schematisch dargestellt. Rechts oben ist das zweite Druckwerkzeug 12 zu sehen, das eine Leitungsunterbrechung 13 an einer anderen Stelle der Leiterbahn aufweist. Durch den zweiten Belichtungs-

0037936

vorgang sind sowohl die beiden ersten Fehler durch den ersten Belichtungsvorgang als auch der durch das Druckwerkzeug 12 gegebene Fehler im Druckgut, das unterhalb des zweiten Druckwerkzeuges 12 dargestellt ist, völlig eliminiert. Man erhält ein vollkommen fehlerfreies Druckbild auf der Leiterplatte 14.

Das Verfahren nach der Erfindung ist über das beschriebene Tentingverfahren hinaus für alle Druckverfahren geeignet, bei denen eine negativ arbeitende Fotopolymerschicht eingesetzt wird.

3 Figuren
3 Patentansprüche.

## Patentansprüche

1. Verfahren zur Herstellung gedruckter Leiterplatten, bei dem die Kupferschicht der nach dem Bohren chemisch verkupferter Platten galvanisch auf die geforderte Endstärke auf der gesamten Fläche einschließlich der Bohrungen in einem Schritt aufgebaut und anschließend die Leiterplatte mit einer negativ arbeitenden Fotopolymerfolie beschichtet wird und nach der Belichtung die nicht belichteten Stellen beim Entwickeln ausgewaschen werden, wonach das freiliegende Kupfer weggeätzt wird (Tenting-Verfahren), d a d u r c h g e k e n n z e i c h n e t, daß zur Erzeugung des Leiterbildes eine zweifache Belichtung erfolgt.

2. Verfahren nach Anspruch 1, d a d u r c h g e -
k e n n z e i c h n e t, daß beim ersten Belichtungsvorgang ein Druckwerkzeug mit den gewünschten Leiterbahn- und Lötaugenabmessungen eingesetzt wird, und daß beim zweiten Belichtungsvorgang ein Druckwerkzeug mit der gleichen Leiterbildkonfiguration wie beim ersten Druck, aber mit geringerer Leiterbreite und kleineren Lötaugendurchmessern eingesetzt wird.

3. Verfahren nach einem der vorhergehenden Ansprüche, d a d u r c h g e k e n n z e i c h n e t, daß der zweite Belichtungsvorgang auf einer anderen Belichtungsstation erfolgt.

0037936

1/2

FIG 1

FIG 2

FIG 3